# EUROPÄISCHE PATENTSCHRIFT

(11) **EP 0 664 613 B1**
(45) Veröffentlichungstag und Bekanntmachung des Hinweises auf die Patenterteilung: **20.02.2002**
(21) Anmeldenummer: 94810725.5
(22) Anmeldetag: 14.12.1994
(51) Int. Cl.: H03K 17/12, H03K 17/082

(54) **Verfahren und Vorrichtung zur Symmetrierung der Belastung parallelgeschalteter Leistungshalbleitermodule**
Method and device for balancing the load on power semiconductor modules connected in parallel
Procédé et dispositif pour équilibrer la sollicitation de modules semi-conducteurs de puissance montés en parallèle

(30) Priorität: 22.01.1994 DE 4401826
(43) Veröffentlichungstag der Anmeldung: 26.07.1995
(73) Patentinhaber: DaimlerChrysler Rail Systems GmbH, 13627 Berlin (DE)
(72) Erfinder: Gerster, Christian, CH-8032 Zürich (CH); Hofer, Patrick, CH-3084 Wabern (CH); Rohner, Ronald Dr., CH-8965 Berikon (CH); Schöb, Reto Dr., CH-8604 Hegnau (CH)
(74) Vertreter: Simons, Johannes, Dipl.-Ing.

(56) Entgegenhaltungen:
- EP-A- 0 288 421
- EP-A- 0 409 384
- WO-A-92/09137
- FR-A- 2 679 082
- US-A- 4 965 710
- ELEKTRIE, Bd. 44, Nr. 10, 1.Januar 1990, BERLIN, DE, Seiten 365-367, XP000176858 H. CONRAD: "SMART POWER DEVICES"

## Beschreibung

### Technisches Gebiet

Die Erfindung bezieht sich auf das Gebiet der Leistungselektronik. Insbesondere bezieht sie sich auf ein Verfahren und eine Vorrichtung zur Symmetrierung der Belastungsverteilung von mindestens zwei parallel geschalteten Schaltermodulen nach dem Oberbegriff von Patentanspruch 1 bzw. 7.

### Stand der Technik

Ein derartiges Verfahren zur Symmetrierung der Belastungsverteilung von mindestens zwei parallel geschalteten Schaltermodulen ist beispielsweise aus der WO 9209137 A bekannt. Dabei umfassen die Schaltermodule mindestens einen Leistungshalbleiterschalter mit einem Gateanschluss, der durch ein pulsförmiges Steuersignal zu beliebigen Schaltzeitpunkten wiederholt ein- bzw. ausschaltbar ist und somit entweder in einem stromleitenden oder einem stromsperrenden Zustand ist. Das Verfahren umfasst ein Messen eines Belastungs-Istwerts jedes Schaltermoduls, ein Bilden einer Differenz zwischen einem Belastungs-Sollwert und dem Belastungs-Istwert und ein Bestimmen und Einstellen von Einschalt- und Ausschaltzeitpunkten des Steuersignals für jeden Leistungshalbleiterschalter anhand der Differenz zwischen Belastungs-Sollwert und Belastungs-Istwert derart, dass im Fall einer negativen Differenz das Schaltermodul beim nächsten Schaltvorgang später eingeschaltet wird und im Fall einer positiven Differenz das Schaltermodul beim nächsten Schaltvorgang früher eingeschaltet wird.

Weiterhin offenbart die Europäische Patentanmeldung EP 0 511 344 eine Parallelschaltung mehrerer Umrichter. Um gleichmässige Belastung - in diesem Fall Stromverteilung - zwischen den Umrichterzweigen zu erhalten, werden die Ausgänge der Umrichterzweige über Anschlussdrosseln zusammengeschaltet. Ist der Strom in einem Umrichterzweig zu gross, so werden durch eine Regelung die Schalter des entsprechenden Umrichterzweigs früher geöffnet, so dass zwischen den Umrichterzweigen ein Ausgleichspfad entsteht und die Ströme aufgrund der Anschlussdrosseln auf alle Umrichterzweige gleichverteilt werden. Beim Schliessen der Schalter kann entsprechend verfahren werden.

Problematisch an dieser Lösung ist jedoch, dass die Induktivität im Lastkreis wegen der Anschlussdrosseln ansteigt und somit die Dynamik der Anordnung verkleinert wird. Insbesondere steigt das Volumen der Anschlussdrosseln mit sinkender Taktfrequenz, was speziell bei tiefen Frequenzen zu sehr grossen Anschlussdrosseln führt.

Eine andere Lösung wird im Vortrag von S. Sone und H. Irinatsu "Very precise turn-off timing control of gate turn-off thyristors", IEEE Conference Publication Nr. 234, 1984, bzw. im entsprechenden Artikel "Serie- oder parallelgeschaltete Hochleistungs-GTOs mit genau synchronisierter Abschaltung", Elektroniker Nr. 3/1985, von A. Stamberger vorgeschlagen. Die GTOs werden in dieser Lösung so angesteuert, dass der Löschverzug aller GTOs unabhängig vom abgeschalteten Durchlassstrom im gleichen Zeitpunkt endet. Alle GTOs werden also zum genau gleichen Zeitpunkt ausgeschaltet.

Problematisch bei dieser Lösung bleibt jedoch, dass ein exakt gleicher Abschaltzeitpunkt noch lange nicht eine Belastungsgleichverteilung bzw. Stromgleichverteilung bedeutet. Vielmehr werden sowohl Parameterunterschiede der externen Beschaltung (Laufzeitunterschiede und Differenzen in den Versorgungs- und Ansteuerspannungen) als auch Parameterunterschiede der Halbleiter selbst (Sättigungsspannung, Schaltzeiten, Schaltverzögerung, etc.) nicht berücksichtigt. Gerade diese Unterschiede führen jedoch inhärent zu unterschiedlichen Strombelastungen in parallelgeschalteten Modulen. Solche Differenzen in der Strombelastung führen jedoch zu einem unnötigen Derating der Stromrichterschaltung, da sonst einzelne Module oder Schalter wegen zu hoher Strombelastung zerstört werden könnten. Ausserdem wird der Einfluss der Temperatur der Schalter auf die Lebensdauer nicht berücksichtigt.

### Darstellung der Erfindung

Aufgabe der vorliegenden Erfindung ist es deshalb, ein Verfahren und eine Vorrichtung zur Symmetrierung der Belastungsverteilung von mindestens zwei parallel geschalteten Schaltermodulen auszubilden, die eine gleichmässige Belastungsverteilung ohne zusätzliche Anschlussdrosseln und insbesondere auch unter Berücksichtigung von Parameterunterschieden und der Temperatur erreicht.

Diese Aufgabe wird durch ein Verfahren mit den Merkmalen von Anspruch 1 sowie durch eine Vorrichtung mit den Merkmalen von Anspruch 7 gelöst.

Bei dem erfindungsgemässen Verfahren werden die Ein- und Ausschaltzeitpunkte jedes Schaltermoduls nach Massgabe der Differenz zwischen Belastungs-Sollwert und Belastungs-Istwert bestimmt und eingestellt. Der Stromfluss des Leistungshalbleiterschalters ist über den Gateanschluss mittels eines pulsförmigen Steuersignals steuerbar. Dabei wird die Höhe des Steuersignals für jedes Schaltermodul derart eingestellt, dass im Fall einer negativen Differenz zwischen einem Belastungs-Sollwert und einem Belastungs-Istwert die Höhe des Steuersignals vermindet wird und im Fall einer positiven Differenz die Höhe des Steuersignals vergrössert wird.

Ein erstes Ausführungsbeispiel verwendet als Belastungs-Istwert eine Temperatur Ts der Schalter. Als Sollwert dient ein von aussen vorgegebener Temperatur-Maximalwert Tmax. Falls der Temperatur-Istwert Ts grösser als der Maximalwert Tmax ist, wird die Höhe der Steuerspannung reduziert. Auf dieser Weise wird erreicht, dass die Belastung der Module möglichst gleichmässig verteilt ist und die Temperatur keines der Module die erlaubte Maximaltemperatur übersteigt.

Ein zweites Ausführungsbeispiel verwendet als Belastungs-Istwert einen Stromistwert, der durch ein Modul fliesst und gemessen wird. Als Sollwert wird ein Stromsollwert verwendet. Ziel dieses Verfahrens ist es, den Gesamtstrom auf alle Module symmetrisch zu verteilen.

Ein besonders bevorzugtes Ausführungsbeispiel des Stromsymmetrierungs-Verfahrens ist dadurch gekennzeichnet, dass für einen Schaltvorgang während des Ein- bzw. Ausschaltzeitpunkts die Differenz zwischen Soll- und Istwert des Stromes durch das Modul gebildet wird, in der Zeit zwischen zwei entsprechenden Schaltzeitpunkten die Ein-bzw. Ausschaltzeitpunkte für den nächstfolgenden Schaltvorgang berechnet werden und die Schalter mit Steuersignalen mit den bestimmten Ein- und Ausschaltzeitpunkten beaufschlagt werden. Gleichzeitig wird wieder die Differenz von Soll- und Istwert des Stromes gemessen etc. Auf diese Weise erreicht man nach einigen Schaltvorgängen eine Stromgleichverteilung in den Modulen, welche sich an Änderungen adaptiv anpasst.

Die Module werden gemäss diesem Verfahren später eingeschaltet und/oder früher ausgeschaltet, falls die Differenz von Soll- und Istwert des Stromes negativ ist bzw. früher ein- und später ausgeschaltet, falls die Differenz positiv ist.

Der Strom kann aber nicht nur transient, d.h. während des Ein- oder Ausschaltens, sondern auch stationär, d.h. währendem die Schalter einen Strom führen, ausgeglichen werden. Diesen stationären Ausgleich erhält man dadurch, dass die Höhe des Steuersignals nachgestellt wird.

Als Stromsollwert kann entweder der Mittelwert des Gesamtstromes oder ein von aussen vorgegebener verwendet werden.

Eine Vorrichtung zur Durchführung des Verfahrens mit der Temperaturmessung umfasst für jedes Module eine Temperaturmesseinrichtung und eine Regeleinheit. In der Regeleinheit wird mittels eines Temperaturvergleichers die Differenz zwischen Temperatur-Maximalwert und gemessenem Istwert gebildet. Anhand dieser Differenz wird in einem Ausgleichsregler die Höhe der Steuerspannung bestimmt und diese wird in einem Steuersignalformer nach Massgabe der im Ausgleichsregler festgelegten Höhe verändert.

Die Vorrichtung zur Durchführung des Stromsymmetrierungs-Verfahrens zeichnet sich dadurch aus, dass für jedes Modul eine Strommesseinrichtung vorgesehen ist, welche den Strom durch das Modul misst. Für jedes Modul ist zudem eine Regeleinheit vorgesehen, in welcher der Vergleich zwischen Stromsoll- und Istwert vorgenommen wird. Zudem ist in der Regeleinheit für jeden Schalter des Moduls je ein Ausgleichsregler und ein Steuersignalformer vorgesehen. Im Ausgleichsregler werden aus der Differenz die Ein- und Ausschaltzeitpunkte sowie die Höhe der Steuersignale berechnet, und im Steuersignalformer werden die Steuersignale anhand der berechneten Ein- und Ausschaltzeitpunkte bzw. Signalhöhen verändert. Mit diesen Steuersignalen werden schliesslich die Schalter der Module beaufschlagt.

Der Stromsollwert für jedes Modul kann entweder durch eine Mittelwertbildung oder durch Vorgabe des Ist-Stromes eines übergeordneten Moduls, das einen vorgegebenen Soll-strom aufweist, gebildet werden.

Weitere Ausführungsbeispiele ergeben sich aus den Unteransprüchen.

Der Vorteil des erfindungsgemässen Aufbaus besteht insbesondere darin, dass die Regelung zur gleichmässigen Belastungsverteilung keine zusätzlichen Anschlussdrosseln benötigt und auch auf Parameterunterschiede der Beschaltung bzw. des Halbleiters sowie auf die Temperatur reagiert.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1a**: Ein Prinzipschaltbild der erfindungsgemässen Vorrichtung zur Stromsymmetrierung mit der dazugehörigen Schalteranordnung nach einer ersten Ausführungsform;
- **Fig. 1b**: Ein Blockschaltbild einer erfindungsgemässen Regeleinheit für ein Modul mit zwei Schaltern;
- **Fig. 1c**: Ein Blockschaltbild eines erfindungsgemässen Steuersignalformers;
- **Fig. 1d**: Ein Blockschaltbild einer Variante zu Figur 1a;
- **Fig. 1e**: Ein Blockschaltbild zu einer weiteren Variante nach Figur 1a;
- **Fig. 2a,b**: Die Beeinflussung des Stromes durch eine Regelung der Ein- bzw. Ausschaltzeitpunkte;
- **Fig. 3a,b**: Die Beeinflussung des Stromes durch eine Regelung der Höhe des Steuersignals;
- **Fig 4a-d**: Messresultate der Stromverteilung mit und ohne erfindungsgemässe Regelung beim Ein- bzw. Ausschalten; und
- **Fig.5a,b**: Messresultate der Stromverteilung mit und ohne erfindungsgemässe Regelung im stationären, leitenden Zustand;
- **Fig 6**: Eine weitere Variante nach Figur 1a mit überlagerter Temperaturregelung; sowie
- **Fig. 7**: Ein Blockschaltbild einer Vorrichtung zur Belastungssymmetrierung anhand einer Temperaturmessung.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

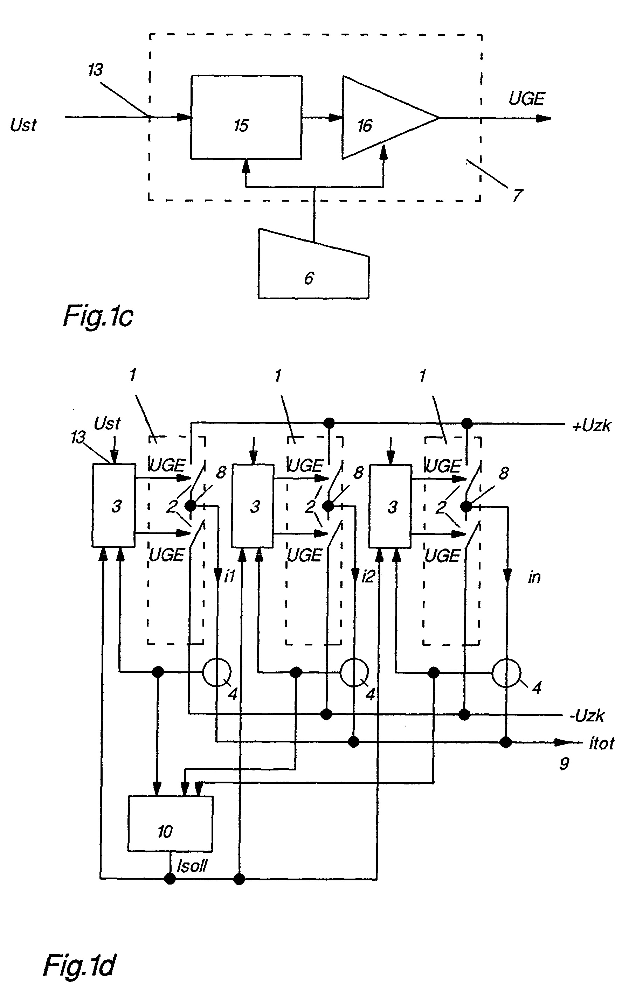

Figur 1a zeigt eine Schaltung, für welche die erfindungsgemässe Regelung mit Strommessung eingesetzt werden kann. Es handelt sich dabei um eine Phase eines Umrichters. Der Umrichter besteht aus mehreren parallel geschalteten Leistungshalbleiter- oder Schaltermodulen (1). Die Schaltermodule (1) bestehen ihrerseits aus Leistungshalbleiterschaltern (2), welche z.B. wie dargestellt z.B. die Zweige einer Brückenschaltung bilden können. In diesem Fall ist zwischen den Schaltern eines Moduls (1) ein Lastanschluss (8) vorhanden. Jedes Modul (1) trägt einen Strom (i1..n) zum Gesamtstrom (itot) bei. Die Schalter (2) der Module (1) werden durch Steuersignalpulse (UGE) wiederholt ein- und ausgeschaltet. Die Schalter (2) der Module (1) sind also entweder im leitenden oder ausgeschalteten Zustand. Bei den Schaltern (2) handelt es sich insbesondere um IGBTs.

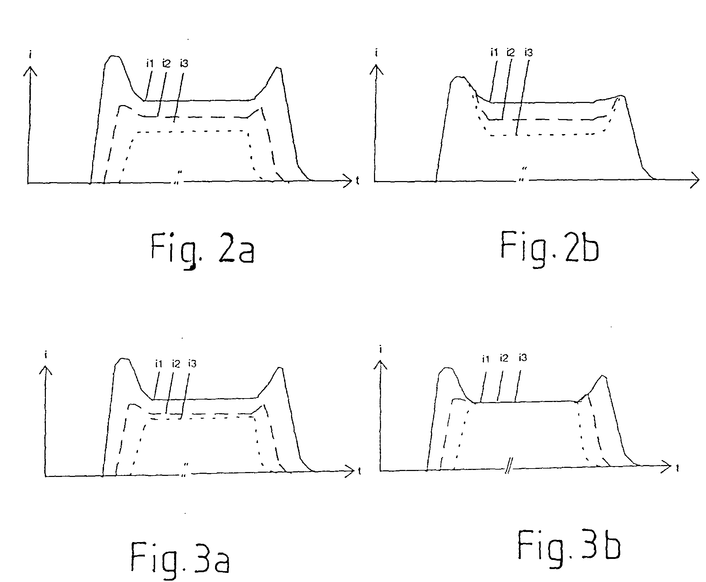

Aufgrund von Parameterunterschieden wie Sättigungsspannung, Schaltzeiten oder Schaltverzögerungen der Schalter (2) oder durch die umgebende Beschaltung (Laufzeitunterschiede etc.) fliesst durch jedes Modul (1) ein unterschiedlicher Strom (i1..n). Und zwar sowohl während der transienten Vorgänge Ein- und Ausschalten (siehe **Figur 2a**) als auch im stationären, leitenden Zustand (**Figur 3a**).

Die Unterschiede der Ströme (i1..n) können derart gross sein, dass die gesamte Schaltung weit überdimensioniert werden muss und unter ihren Möglichkeiten betrieben werden muss ("Derating"). Wird nämlich nicht andauernd gewährleistet, dass die Schalter ihren Betriebsbereich ("Safe Operating Area SOA") nicht verlassen, könnten unter Umständen ein oder mehrere Schalter (2) zerstört werden.

Dem versucht die erfindungsgemässe Regelung nun entgegenzuwirken, indem sie dafür sorgt, dass der Gesamtstrom (itot) gleichmässig auf die Module (1) verteilt wird und keiner der Schalter (2) seine SOA verlässt.

Dies wird nun durch die Erfindung dadurch erreicht, dass die Ein- und Ausschaltzeitpunkte (ton, toff) des Steuersignals (UGE) für jeden Schalter (2) so eingestellt werden, dass beim Ein- bzw. Ausschalten eine gleichverteilte Strombelastung erreicht wird. Zudem wird während dem Leiten der Module (1) die Höhe der Steuerspannung (UGE) für die leitenden Schalter so eingestellt, dass auch hier die Strombelastung gleich gross wird.

Für jedes Schaltermodul (1) wird also für jeden Ein- und Ausschaltzeitpunkt (ton, toff) eine Differenz zwischen einem Strom-Sollwert (isoll1..n) und dem gemessenen Strom-Istwert (i1..n) gebildet. Aus dieser Differenz werden nun in der Zeit zwischen zwei entsprechenden Schaltzeitpunkten die Ein- und Ausschaltzeitpunkte (ton, toff) für den nächsten Schaltvorgang bestimmt. Die Schalter (2) der Module (1) werden schliesslich mit Steuersignalen (UGE), welche die vorgängig bestimmten Schaltzeitpunkte aufweisen, beaufschlagt. Gleichzeitig wird bereits wieder die Differenz zwischen Strom-Sollwert und Strom-Istwert gebildet usw. Dadurch erhält man mit der Zeit eine gleichmässige Aufteilung der Ströme (i1..n) auf alle Module (1).

Anhand des Vorzeichens der Differenz zwischen Soll- und Istwert des Stromes kann entschieden werden, ob die Schalter (2) der Module (1) beim nächsten Schaltvorgang früher oder später ein- bzw. ausgeschaltet werden sollen. Die Module (1) werden insbesondere später eingeschaltet, falls die Differenz negativ, d.h. der Ist-Strom grösser als der Sollstrom ist. Umgekehrt werden die Module (1) früher eingeschaltet, falls die Differenz positiv, d.h. der Ist-Strom kleiner als der Soll-Strom ist. Zudem kann auch der Ausschaltzeitpunkt beeinflusst werden. Bei negativer Differenz werden die Module früher ausgeschaltet, bei positiver später.

Durch diese gezielte Beeinflussung der Schaltzeitpunkte kann also die Stromaufteilung auf die Module (1) während der transienten Schaltvorgänge ausgeglichen werden. Wie **Figur 3a** zeigt, fliessen aber durch die Module nicht nur beim Schalten unterschiedliche Ströme, sondern auch im stationären, leitenden Zustand. Der Strom durch einen IGBT oder ein verwandtes Element kann nun dadurch beeinflusst werden, dass die Höhe der Steuerspannung (UGE) vergrössert oder verkleinert wird. Auf diese Weise gelingt es, auch im stationären Zustand ein gleichverteilte Stromaufteilung zu erhalten. Dies wird insbesondere dadurch erreicht, dass laufend eine Differenz zwischen dem Strom-Sollwert (isolll..n) und dem gemessenen Strom-Istwert (i1..n) gebildet wird. Falls die Differenz negativ ist, wird die Höhe des Steuersignals vermindert, falls sie positiv ist vergrössert.

Auf diese Weise erhält man auch im stationären, leitenden Zustand der Schalter (2) eine gleichmässige Stromverteilung auf die Module (1), siehe **Figur 3b**.

Der Stromsollwert für jedes Modul (1) kann z.B. dadurch errechnet werden, dass der Gesamtstrom (itot) der parallelgeschalteten Module gemessen wird und durch die Anzahl der Module (1) geteilt wird. Ebenso kann die Summe der gemessenen Ist-Ströme (i1..n) gebildet und daraus ein Mittelwert berechnet werden.

Falls man jedem Modul (1) einen eigenen Sollwert (isoll1..n) vorgibt, ist das Regelsystem überbestimmt, und das System kann unter Umständen instabil werden. Deshalb besteht eine weitere Variante der Sollwertbildung darin, dass man einem ersten Modul einen Sollwert (isoll1) vorgibt und bei den übrigen Modulen den Ist-Strom (i1) des ersten Moduls als Sollwert (isoll2..n) verwendet. Auf diese Weise erreicht man auch eine gleichmässige Aufteilung der Ströme auf die Module (1).

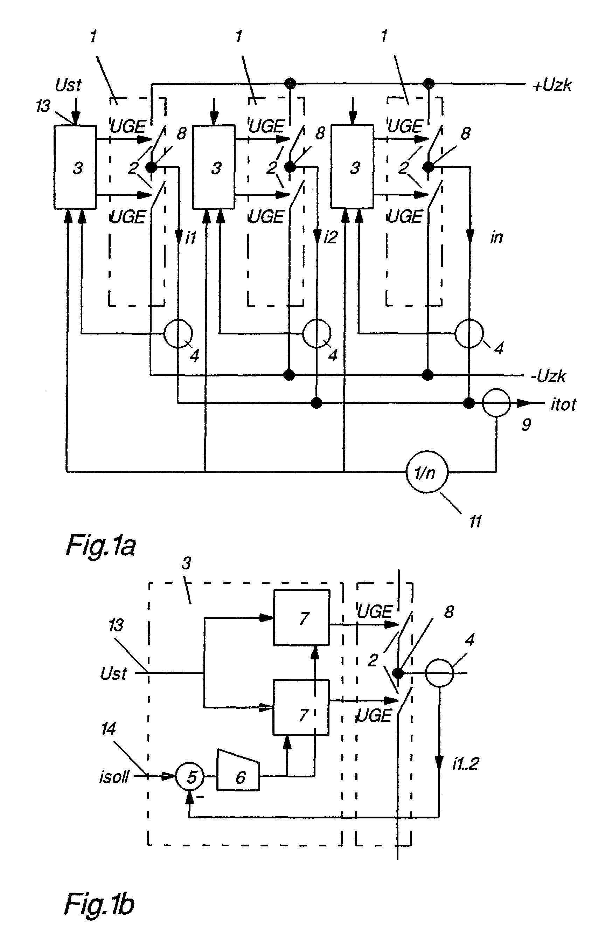

Ein mögliche Vorrichtung zur Durchführung des oben erläuterten Verfahrens ist für ein Modul (1) in der **Figuren 1a-e** dargestellt. Das Modul (1) umfasst im dargestellten Fall zwei Schalter (2), welche in Serie geschaltet sind und mit ihrem gemeinsamen Knoten einen Lastanschluss (8) einer Brückenschaltung bilden. Wie in Figur 1a dargestellt ist, muss man sich parallel zu dem in Figur 1b dargestellten Modul noch die übrigen, parallelgeschalteten Module vorstellen. Die Schalter (2) werden durch Steuersignale (UGE) geschlossen oder geöffnet. Das Steuersignal (UGE) ist pulsförmig und wird von einer nicht dargestellten Steuersignalquelle geliefert.

Für jedes Modul (1) ist nun eine Regeleinheit (3) vorgesehen, welche die von aussen vorgegebenen Steuersignale (USt) so verändert, dass die gewünschte Stromsymmetrierung erreicht wird. Zu diesem Zweck wird am Lastanschluss (8) der Schalter (2) mittels einer Strommesseinrichtung (4) ein Strom (i1..n) gemessen und der Regeleinrichtung (3) zugeführt. Dieser Ist-Strom (i1..n) wird nun mit einem Soll-Strom (isoll1..n) verglichen. Der Soll-Strom (isoll1..n) kann wie oben erläutert auf verschieden Arten gebildet werden. Der Vergleich geschieht in einem Differenzbildner (5). In einem nachgeschalteten Ausgleichsregler (6) werden nun anhand der Differenz zwischen Soll- und Istwert die geforderten Ein- und Ausschaltzeitpunkte (ton, toff) bzw. die Höhe des Steuersignals (UGE) berechnet.

Im Steuersignalformer (7) werden nun anhand dieser Werte die Flanken des von der Steuersignalquelle vorgegebenen Signals (Ust) mittels einer Verzögerungsschaltung (15) entsprechend der berechneten Ein- und Ausschaltzeitpunkten (ton, toff) beeinflusst. Zudem wird anhand der Differenz, welche während dem Leiten der Schalter gebildet wurde, die geforderte Höhe des Steuersignals (UGE) berechnet und mittels eines Verstärkers (16) laufend nachgestellt.

Für die Bildung des Strom-Sollwertes kann entweder eine Gesamtstrommesseinrichtung (9) mit nachgeschaltetem Teiler (11) (Figur 1a) oder ein Mittelwertbildner (10) (Figur ld) vorgesehen sein.

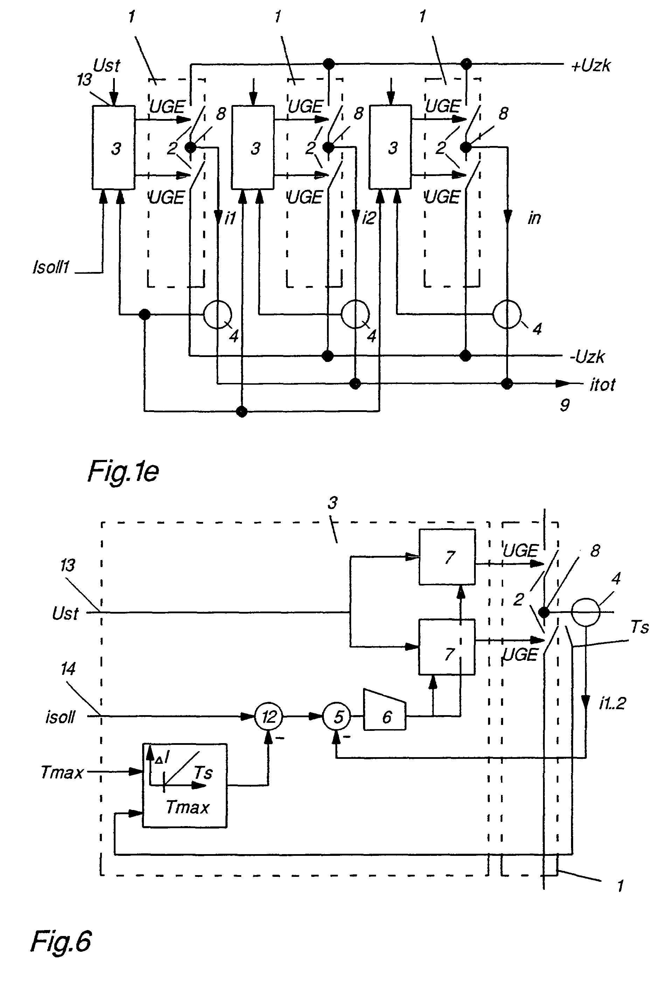

Eine weitere Variante, die in Figur 1e dargestellt ist, besteht darin, dass einem ersten Modul ein Sollwert (isoll1) von aussen vorgegeben wird und für die übrigen Module der Istwert (i1) des ersten Moduls als Sollwert (isoll2..n) verwendet wird (Figur 1e).

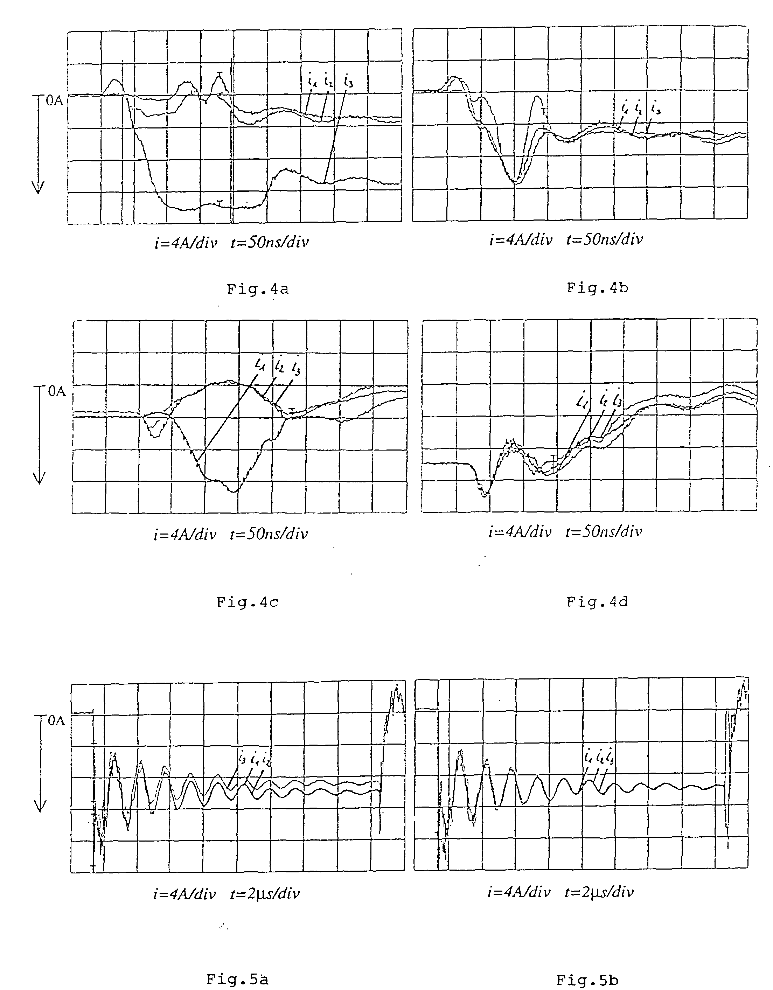

In den **Figuren 4a-d und 5a-b** sind schliesslich Messresultate dargestellt, die mit einem Versuchsaufbau erzielt wurden. Für drei Module (1) wurden die Ströme beim Einschalten (Figuren 4a,b), beim Ausschalten (Figuren 4c,d) und beim Leiten (Figuren 5a,b) gemessen sowohl mit wie ohne erfindungsgemässe Regelung gemessen. Wie man deutlich sieht, sind die Ströme (i1..3) bei den Versuchen mit Regelung (Figuren 4b,4d,5b) sehr viel besser symmetriert, als bei den Versuchen ohne erfindungsgemässe Regelung (Figuren 4a,4c,5a).

Der oben dargelegten Regelung kann zudem eine Regelung der thermischen Belastung überlagert sein. Dies ist von besonderem Vorteil, denn aus der effektiven Junction Temperatur der Schalter kann direkt auf eine mögliche Gefahr der Zerstörung geschlossen werden. So ist durchaus erlaubt, dass ein Schalter gegebenenfalls einen höheren Strom führt als erlaubt, solange die Junction Temperatur nicht zu gross wird, schadet dies dem Schalter nicht.

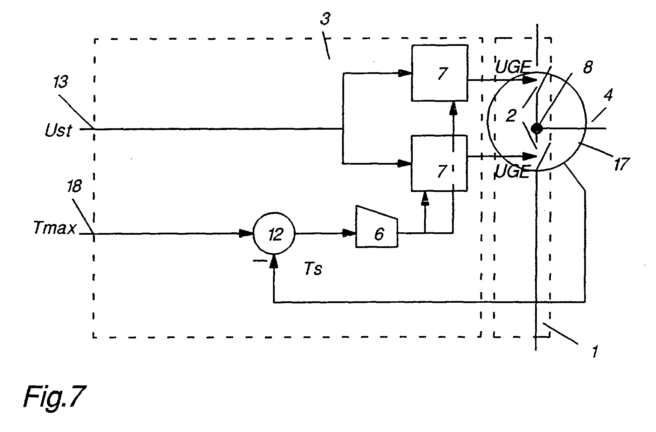

**Figur 6** zeigt eine mögliche Realisierung einer solchen kombinierten Strom- und Temperaturregelung: Der Istwert der Temperatur Ts wird direkt auf den Schaltern (2) gemessen und in einem Temperaturvergleicher (12) mit einem vorgegebenen Maximalwert Tmax verglichen. Anhand dieses Vergleichs wird nun der Sollstromwert (Isoll1..n) in einem zweiten Differenzbildner (15) beeinflusst. Der zweite Differenzbildner (15) ist dabei dem ersten (5) vorgeschaltet und steht mit dem Sollwerteingang (14) und dem Ausgang des Temperaturvergleichers (12) in Verbindung. Ist die Temperatur Ts höher als die maximal erlaubte Tmax, so wird vom Sollstromwert (isoll) verkleinert. Zum Beispiel wird ein Betrag abgezogen, der proportional zur festgestellten Temperaturdifferenz ist. Auf diese Weise wird wirksam vermieden, dass ein Schalter mit einem Strom belastet wird, der eine zu hohe Junction Temperatur zur Folge hat und damit zur Zerstörung des Schalters führen könnte.

Diese übergeordnete Temperaturregelung kann natürlich entsprechend auch auf die übrigen Arten der Strom-Soll-wertbestimmung übertragen werden.

**Figur 7** zeigt schliesslich ein Ausführungsbeispiel einer Vorrichtung zur Durchführung des Verfahrens mit der Temperaturmessung. Für jedes Modul (1) ist wiederum eine Regeleinheit (3) vorgesehen. Anstatt eines Stromsollwert-Eingangs (14) ist nun ein Temperatur-Maximalwert-Eingang (18) vorgesehen. In einer Temperaturmesseinrichtung (17) wird die Temperatur Ts der Schalter (2) eines Moduls (1) gemessen. Diese Temperatur Ts wird anschliessend in einem Temperaturvergleicher (12) - z.B. einem Differenzbildner - mit dem Maximalwert Tmax verglichen. Das Ergebnis des Vergleichs wird einem Ausgleichsregler (6) zugeführt, in welchem, falls die Differenz zwischen Temperatur-Istwert Ts und Maximalwert Tmax negativ ist, eine Reduktion der Höhe der Steuerspannung (UGE) berechnet wird. Pro Schalter (2) ist zudem ein Steuersignalformer (7) vorgesehen, in welchem das am Steuersignal-Eingang (13) anliegende Steuersignal (Ust) nach Massgabe der im Ausgleichsregler (6) berechneten Werte verändert wird.

Insgesamt steht also mit der Erfindung ein wirksames Regelverfahren zur Symmetrierung der Belastung in parallel geschalteten Leistungshalbleitermodulen zur Verfügung. Mit diesem Verfahren erreicht man insbesondere die Vorteile, dass dadurch kein Modul überlastet wird und die Module in ihrem vorgesehenen Leistungsbereich eingesetzt werden können ohne Derating. Durch diese Regelung wird zudem gewährleistet, dass die Module bzw. deren Schalter den sicheren Betriebsbereich (Safe Operating Area SOA) sowohl bezüglich Strom- als auch bezüglich Temperaturbelastung nicht verlassen.

### Bezeichnungsliste

- 1: Schaltermodul
- 2: Leistungshalbleiterschalter
- 3: Regeleinheit
- 4: Strommesseinrichtung
- 5: Vergleicher/Differenzbildner
- 6: Ausgleichsregler
- 7: Steuersignalformer
- 8: Lastanschluss
- 9: Gesamtstrommesseinrichtung
- 10: Mittelwertbildner
- 11: Teiler
- 12: Temperaturvergleicher
- 13: Steuersignaleingang
- 14: Sollwerteingang
- 15: Verzögerungsschaltung
- 16: Verstärker
- 17: Temperaturmesseinrichtung
- 18: Eingang für den Temperatur-Maximalwert
- UGE: Steuersignal der Schalter
- ton: Einschaltzeitpunkt
- toff: Ausschaltzeitpunkt
- il..n: Ströme durch Module 1..n
- isoll1..n: Sollströme der Module 1..n
- itot: Gesamtstrom
- n: Anzahl Module
- ±Uzk: Zwischenkreisanschlüsse
- Ust: Steuersignal von aussen
- Ts: Temperatur
- Tmax: Maximalwert der Temperatur

## Patentansprüche

1. Verfahren zur Symmetrierung der Belastungsverteilung von mindestens zwei parallel geschalteten Schaltermodulen (1), wobei die Schaltermodule (1) mindestens einen Leistungshalbleiterschalter (2) mit einem Gateanschluss umfassen, der durch ein pulsförmiges Steuersignal (UGE) zu beliebigen Schaltzeitpunkten (ton, toff) wiederholt ein-bzw. ausschaltbar ist und somit entweder in einem stromleitenden oder einem stromsperrenden Zustand ist,
mit den Schritten
a) Messen eines Belastungs-Istwerts jedes Schaltermoduls (1),
b) Bilden einer Differenz zwischen einem Belastungs-Sollwert und dem Belastungs-Istwert und
c) Bestimmen und Einstellen von Einschalt- und Ausschaltzeitpunkten (ton, toff) des Steuersignals (UGE) für jeden Leistungshalbleiterschalter (2) anhand der Differenz zwischen Belastungs-Sollwert (isoll1..n; Tmax) und Belastungs-Istwert (i1..n; Ts) derart, dass im Fall einer negativen Differenz das Schaltermodul (1) beim nächsten Schaltvorgang später eingeschaltet wird und im Fall einer positiven Differenz das Schaltermodul (1) beim nächsten Schaltvorgang früher eingeschaltet wird,
**dadurch gekennzeichnet, dass**
der Stromfluss des Leistungshalbleiterschalters (2) über den Gateanschluss mittels des pulsförmigen Steuersignals (UGE) steuerbar ist,
mit dem weiteren Schritt
d) Einstellen der Höhe des Steuersignals (UGE) für jedes Schaltermodul (1) derart, dass im Fall einer negativen Differenz zwischen einem Belastungs-Sollwert und einem Belastungs-Istwert die Höhe des Steuersignals vermindert wird und im Fall einer positiven Differenz die Höhe des Steuersignals vergrössert wird.

2. Verfahren nach Anspruch 1, **dadurch gekennzeichnet, dass**
im Schritt a) als Belastungs-Istwert eine Temperatur Ts der Leistungshalbleiterschalter (2) jedes Schaltermoduls (1) gemessen wird,
als Belastungs-Sollwert pro Schaltermodul (1) ein Temperatur-Maximalwert Tmax vorgegeben wird und
in Schritt b) als die Differenz zwischen Belastungs-Sollwert und Belastungs-Istwert eine Differenz zwischen dem Temperatur-Maximalwert Tmax und der Temperatur Ts des Leistungshalbleiterschalters (2) gebildet wird.

3. Verfahren nach Anspruch 1, **dadurch gekennzeichnet, dass**
in Schritt a) als Belastungs-Istwert ein Ist-Strom (i1..n) durch jedes Schaltermodul (1) gemessen wird,
als Belastungs-Sollwert pro Schaltermodul (1) ein Strom-Sollwert (isoll1..n) vorgegeben wird und
in Schritt b) als Differenz zwischen Belastungs-Sollwert und Belastungs-Istwert eine Differenz zwischen dem Strom-Sollwert (isoll1..n) und dem Ist-Strom (i1..n) verwendet wird.

4. Verfahren nach Anspruch 3, **gekennzeichnet durch** den weiteren Schritt
Messen des Gesamtstroms (itot) und Berechnen des n-ten Teils des gemessenen Gesamtstromes (itot) als Strom-Sollwert (isoll1..n), wobei n der Anzahl parallelgeschalteter Schaltermodule (1) entspricht.

5. Verfahren nach Anspruch 3, **dadurch gekennzeichnet, dass**
einem ersten Schaltermodul (1) ein Strom-Sollwert (isoll1) vorgegeben wird und für die Strom-Sollwerte (isoll2..n) der übrigen Schaltermodule (1) der Ist-Strom (i1) des ersten Schaltermoduls (1) verwendet wird.

6. Verfahren nach einem der Ansprüche 3 bis 5, **gekennzeichnet durch** die weiteren Schritte Messen einer Temperatur Ts der Leistungshalbleiterschalter (2),
Bilden je einer Differenz zwischen einem Temperatur-Maximalwert Tmax und den gemessenen Temperaturen Ts und
Verkleinern des Strom-Sollwerts (isoll1..n) in Abhängigkeit vom Betrag der Differenz, falls die gemessene Temperatur Ts den Maximalwert Tmax überschreitet.

7. Vorrichtung zur Symmetrierung der Belastungsverteilung von mindestens zwei parallel geschalteten Schaltermodulen (1), mit:
a) mindestens zwei parallel geschalteten Schaltermodulen (1), wobei die Schaltermodule (1) mindestens einen Leistungshalbleiterschalter (2) mit einem Gateanschluss umfassen, der durch ein pulsförmiges Steuersignal (UGE) zu beliebigen Schaltzeitpunkten (ton, toff) wiederholt ein- bzw. ausschaltbar ist und somit entweder in einem stromleitenden oder einem stromsperrenden Zustand ist,
b) einer Einrichtung zur Messung eines Belastungs-Istwerts jedes Schaltermoduls (1), einer Einrichtung zur Bildung einer Differenz zwischen einem Belastungs-Sollwert und dem Belastungs-Istwert,
c) einer Einrichtung zur Einstellung von Einschalt- und Ausschaltzeitpunkten (ton, toff) des Steuersignals (UGE) für jeden Leistungshalbleiterschalter (2) anhand der Differenz zwischen Belastungs-Sollwert (isoll1..n; Tmax) und Belastungs-Istwert (i1..n; Ts) derart, dass im Fall einer negativen Differenz das Schaltermodul (1) beim nächsten Schaltvorgang später einzuschalten ist und im Fall einer positiven Differenz das Schaltermodul (1) beim nächsten Schaltvorgang früher einzuschalten ist,
**dadurch gekennzeichnet, dass**
der Stromfluss über den Gateanschluss mittels eines pulsförmigen Steuersignals (UGE) steuerbar ist und
d) eine Einrichtung ausgebildet ist zur Einstellung der Höhe des Steuersignals (UGE) für jedes Schaltermodul (1) derart, dass im Fall einer negativen Differenz zwischen einem Belastungs-Sollwert und einem Belastungs-Istwert die Höhe des Steuersignals zu vermindern ist und im Fall einer positiven Differenz die Höhe des Steuersignals zu vergrössern ist.

8. Vorrichtung nach Anspruch 7, **dadurch gekennzeichnet, dass**
die Einrichtung zur Messung eines Belastungs-Istwerts eine Temperaturmesseinrichtung (17) ausgangsseitig jedes Schaltermoduls (1) ist, die eine Temperatur Ts der Leistungshalbleiterschalter (2) misst,
jedes Schaltermodul (1) eine Regeleinheit (3) mit einem Steuersignaleingang (13), der von einer Steuersignalquelle gespeist wird, und einem Eingang (18) für den Temperatur-Maximalwert Tmax aufweist, wobei
jede Regeleinheit (3) als eine Einrichtung zur Bildung einer Differenz zwischen einem Belastungs-Sollwert und dem Belastungs-Istwert einen Temperaturvergleicher (12) umfasst, der die Differenz zwischen dem Temperatur-Maximalwert Tmax und der in der entsprechenden Temperaturmesseinrichtung (17) gemessenen Temperatur Ts bildet, und
jede Regeleinheit (3) als Einrichtung zur Einstellung der Höhe des Ausgangssignals einen Ausgleichsregler (6), in dem anhand der Differenz zwischen Temperatur-Maximalwert Tmax und der gemessenen Temperatur Ts die Höhe der Steuersignale (UGE) festgelegt wird, und pro Leistungshalbleiterschalter (2) ein Steuersignalformer (7) aufweist, in dem das am Steuersignaleingang (13) anliegende Signal (Ust) nach Massgabe der im Ausgleichsregler (6) festgelegten Steuersignalhöhe (UGE) verändert wird.

9. Vorrichtung nach Anspruch 7, **dadurch gekennzeichnet, dass**
die Einrichtung zur Messung eines Belastungs-Istwerts eine Strommesseinrichtung (4) ausgangsseitig jedes Schaltermoduls (1) ist, die den Strom-Istwert (i1..n) der Leistungshalbleiterschalter (2) misst,
jedes Schaltermodul (1) eine Regeleinheit (3) mit einem Steuersignaleingang (13), der von einer Steuersignalquelle gespeist wird, und einem Eingang (14) für den Strom-Sollwert (isoll1..n) aufweist, wobei
jede Regeleinheit (3) als Einrichtung zur Bildung einer Differenz einen Differenzbildner (5) umfasst, der eine Differenz zwischen dem Strom-Sollwert (isoll1..n) und dem in der entsprechenden Strommesseinrichtung (4) gemessenen Strom-istwert (i1..n) bildet, und
in jeder Regeleinheit pro Schaltermodul (1) als Einrichtung zur Einstellung der Höhe des Steuersignals ein Ausgleichsregler (6), in dem anhand der Differenz die Ein- bzw. Ausschaltzeitpunkte (ton, toff) und die Höhe der Steuersignale (UGE) festgelegt werden, und pro Leistungshalbleiterschalter (2) ein Steuersignalformer (7) vorgesehen ist, in dem das am Steuersignaleingang (13) anliegende Signal (Ust) nach Massgabe der im Ausgleichsregler (6) festgelegten Ein- bzw. Ausschaltzeitpunkte (ton, toff) und Steuersignalhöhen (UGE) verändert wird.

10. Vorrichtung nach Anspruch 9, **dadurch gekennzeichnet, dass**
am Ausgang (8) der Parallelschaltung der Schaltermodule (1) eine weitere Strommesseinrichtung (9) ausgebildet ist, die eine Summe der von den Schaltermodulen (1) abgegebenen Ströme (i1..n) misst, diesen Summenstrom (itot) durch die Anzahl der Schaltermodule (1) teilt und an den Eingang (14) für den Strom-Sollwert der Regeleinheit (3) weitergibt.

11. Vorrichtung nach Anspruch 9, **dadurch gekennzeichnet, dass**
ein Mittelwertbildner (10) vorgesehen ist, der einen Mittelwert der in den Strommesseinrichtungen (4) der Schaltermodule (1) gemessenen Ist-Ströme (i1..n) bildet und diesen als Strom-Sollwert (isoll1..n) an den Eingang (14) für den Strom-Sollwert der Regeleinheit (3) weitergibt.

12. Vorrichtung nach Anspruch 9, **dadurch gekennzeichnet, dass**
einem ersten Schaltermodul (1) von aussen ein Strom-Sollwert (isoll1) vorgegeben wird und die Eingänge (14) für den Strom-Sollwert der Regeleinheiten (3) der übrigen Schaltermodule (1) mit der Strommesseinrichtung (4) des ersten Schaltermoduls (1) verbunden sind.

13. Vorrichtung nach einem der Ansprüche 9 bis 12, **dadurch gekennzeichnet, dass**
ein Temperaturvergleicher (12) vorgesehen ist, der eine Differenz zwischen einem Temperatur-Maximalwert Tmax und einer auf den Leistungshalbleiterschaltern (2) gemessenen Temperatur Ts bestimmt,
dem Differenzbilder (5) ein weiterer Differenzbilder (15) vorgeschaltet ist, der vom Strom-Sollwert (isoll1..n) einen Betrag proportional zur festgestellten Differenz zwischen dem Temperatur-Maximalwert Tmax und der gemessenen Temperatur Ts abzieht, wenn die gemessene Temperatur Ts den Maximalwert Tmax überschreitet.

## Claims

1. Method for balancing the load distribution between at least two parallel-connected switch modules (1), with the switch modules (1) comprising at least one power semiconductor switch (2) with a gate connection which can be switched on and off repeatedly at any desired times (ton, toff) by means of a pulsed control signal (UGE) and is thus either in a switched-on or a switched-off state, having the steps:
a) measurement of a load actual value for each switch module (1),
b) formation of a difference between a load nominal value and the load actual value, and
c) determination and setting of switching-on and switching-off times (ton, toff) for the control signal (UGE) for each power semiconductor switch (2) on the basis of the difference between the load nominal value (inom1..n; Tmax) and the actual value (i1..n; Ts), in such a manner that, if the difference is negative, the switch module (1) is switched on later in the next switching process and, if the difference is positive, the switch module (1) is switched on earlier in the next switching process,
**characterized in that**
the current flow through the power semiconductor switch (2) via the gate connection can be controlled by means of the pulsed control signal (UGE),
and having the further step:
d) setting of the magnitude of the control signal (UGE) for each switch module (1) in such a manner that, if the difference between a load nominal value and a load actual value is negative, the magnitude of the control signal is reduced, and if the difference is positive, the magnitude of the control signal is increased.

2. Method according to Claim 1, **characterized in that**,
in step a), a temperature Ts of the power semiconductor switches (2) in each switch module (1) is measured as the load actual value,
a temperature maximum value Tmax is pre-set as the load nominal value for each switch module (1), and, in step b), a difference between the temperature maximum value Tmax and the temperature Ts of the power semiconductor switch (2) is formed as the difference between the load nominal value and the load actual value.

3. Method according to Claim 1, **characterized in that** in step a), an actual current (i1..n) through each switch module (1) is measured as the load actual value,
a current nominal value (inom1..n) is pre-set as the load nominal value for each switch module (1), and,
in step b) a difference between the current nominal value (inom1..n) and the actual current (i1..n) is used as the difference between the load nominal value and the load actual value.

4. Method according to Claim 3, **characterized by** the further step:
measurement of the total current (itot) and calculation of the n-th part of the measured total current (itot) as the current nominal value (inom1..n), where n corresponds to the number of parallel-connected switch modules (1).

5. Method according to Claim 3, **characterized in that** a current nominal value (inom1) is pre-set for a first switch module (1), and the actual current (i1) for the first switch module (1) is used for the current nominal values (1nom2..n) for the other switch modules (1).

6. Method according to one of Claims 3 to 5, **characterized by** the further steps:
measurement of a temperature Ts of the power semiconductor switches (2),
formation in each case of a difference between a temperature maximum value Tmax and the measured temperatures Ts, and
reduction of the current nominal value (inom1..n) as a function of the magnitude of the difference, if the measured temperature Ts exceeds the maximum value Tmax.

7. Apparatus for balancing the load distribution for at least two parallel-connected switch modules (1), having:
a) at least two parallel-connected switch modules (1), with the switch modules (1) comprising at least one power semiconductor switch (2) with a gate connection which can be switched on and off repeatedly at any desired switching times (ton, toff) by a pulsed control signal (UGE) and is thus either in a switched-on or a switched-off state,
b) a device for measuring a load actual value for each switching module (1),
a device for forming a difference between a load nominal value and the load actual value,
c) a device for setting switching-on and switching-off times (ton, toff) for the control signal (UGE) for each power semiconductor switch (2) on the basis of the difference between the load nominal value (inom1..n; Tmax) and the load actual value (i1..n; Ts), in such a manner that, if the difference is negative, the switch module (1) can be switched on later during the next switching process and, if the difference is positive, the switch module (1) can be switched on earlier during the next switching process,
**characterized in that**
the current flow via the gate connection can be controlled by means of a pulsed control signal (UGE), and
d) a device is formed for setting the magnitude of the control signal (UGE) for each switch module (1) in such a manner that, if the difference between a load nominal value and a load actual value is negative, the magnitude of the control signal can be reduced and, if the difference is positive, the magnitude of the control signal can be increased.

8. Apparatus according to Claim 7, **characterized in that**
the device for measuring a load actual value is a temperature measurement device (17) on the output side of each switch module (1), which measures a temperature Ts of the power semiconductor switches (2),
each switch module (1) has a control unit (3) with a control signal input (13) which is supplied from a control signal source, and with an input (18) for the temperature maximum value Tmax, with
each control unit (3) having a temperature comparator (12) as a device for forming a difference between a load nominal value and the load actual value, which temperature comparator (12) forms the difference between the temperature maximum value Tmax and the temperature Ts measured in the corresponding temperature measurement device (17), and each control unit (3) has a compensation regulator (6) as the device for setting the magnitude of the output signal, in which the magnitude of the control signals (UGE) is defined on the basis of the difference between the temperature maximum value Tmax and the measured temperature Ts, and has a control signal former (7) for each power semiconductor switch (2), in which the signal (Ust) which is applied to the control signal input (13) is varied depending on the control signal magnitude (UGE) defined by the compensation regulator (6).

9. Apparatus according to Claim 7, **characterized in that**
the device for measuring a load actual value is a current measurement device (4) on the output side of each switch module (1), which measures the current actual value (i1..n) of the power semiconductor switches (2),
each switch module (1) has a control unit (3) with a control signal input (13), which is supplied from a control signal source, and an input (14) for the current nominal value (inom1..n), with
each control unit (3) having a subtractor (5) as the device for forming a difference, which subtractor (5) forms a difference between the current nominal value (inom1..n) and the current actual value (i1..n) measured in the corresponding current measurement device (4), and
a compensation regulator (6) being provided for each switch module (1) in each control unit as the device for setting the magnitude of the control signal, in which compensation regulator (6) the difference is used to define the switching-on and switching-off times (ton, toff) and the magnitude of the control signals (UGE), and a control signal former (7) being provided for each power semiconductor switch (2), in which the signal (Ust) applied to the control signal input (13) is varied as a function of the switching-on and switching-off times (ton, toff) and control signal magnitudes (UGE) defined in the compensation regulator (6).

10. Apparatus according to Claim 9, **characterized in that**
a further current measurement device (9) is formed at the output (8) of the parallel circuit of the switch modules (1) and measures a sum of the currents (i1..n) emitted from the switch modules, divides this total current (itot) by the number of switch modules (1) and passes this on to the input (14) for the current nominal value for the control unit (3).

11. Apparatus according to Claim 9, **characterized in that**
an averager (10) is provided, which forms a mean value of the actual currents (i1..n) measured in the current measurement devices (4) in the switch modules, and which passes these on as the current nominal value (inom1..n) to the input (14) for the current nominal value for the control unit (3).

12. Apparatus according to Claim 9, **characterized in that**
a current nominal value (inom1) is pre-set from the outside for a first switch module (1), and the inputs (14) for the current nominal value for the control units (3) of the other switch modules (1) are connected to the current measurement device (4) of the first switch module (1).

13. Apparatus according to one of Claims 9 to 12,
**characterized in that**
a temperature comparator (12) is provided, which determines a difference between a temperature maximum value Tmax and a temperature Ts measured at the power semiconductor switches (2),
the subtractor (5) is preceded by a further subtractor (15), which subtracts from the current nominal value (inom1..n) an amount which is proportional to the defined difference between the temperature maximum value Tmax and the measured temperature Ts, if the measured temperature Ts exceeds the maximum value Tmax.

## Revendications

1. Procédé pour symétriser la répartition de la charge d'au moins deux modules de commutation (1) branchés en parallèle, les modules de commutation (1) comprenant au moins un commutateur à semiconducteur de puissance (2) avec une borne de gâchette, lequel peut être activé ou désactivé manière répétée à des moments de commutation quelconques (ton, toff) à l'aide d'un signal de commande impulsionnel (UGE) et prend ainsi un état passant ou un état bloqué, ayant pour étapes
a) Mesure d'une valeur réelle de la charge de chaque module de commutation (1),
b) Calcul d'une différence entre une valeur de consigne de charge et la valeur réelle de la charge et
c) Détermination et réglage des moments d'activation et de désactivation (ton, toff) du signal de commande (UGE) de chaque commutateur à semiconducteur de puissance (2) au moyen de la différence entre la valeur de consigne de la charge (isoll1..n ; Tmax) et la valeur réelle de la charge (i1..n ; Ts) de telle manière qu'en cas de différence négative le module de commutation (1) soit activé plus tard à la prochaine commutation et, en cas de différence positive, le module de commutation (2) soit activé plus tôt à la prochaine commutation,
**caractérisé en ce que** l'intensité du courant dans le commutateur à semiconducteur de puissance (2) peut être commandée par le biais de la borne de gâchette à l'aide du signal de commande impulsionnel (UGE),
ayant pour étape supplémentaire
d) Réglage de l'amplitude du signal de commande (UGE) pour chaque module de commutation (1) de telle manière qu'en cas de différence négative entre la valeur de consigne de la charge et une valeur réelle de la charge, l'amplitude du signal de commande soit diminuée et, en cas de différence positive, qu'elle soit augmentée.

2. Procédé selon la revendication 1, **caractérisé en ce que**
dans l'étape a) la valeur réelle mesurée de la charge est une température Ts du commutateur à semiconducteur de puissance (2) de chaque module de commutation (1),
la valeur de consigne de la charge de chaque module de commutation (1) soit une valeur maximale prédéfinie de la température Tmax et
dans l'étape b), la différence entre la valeur de consigne de la charge et la valeur réelle de la charge soit calculée sous la forme d'une différence entre la valeur maximale de la température Tmax et la température Ts du commutateur à semiconducteur de puissance (2).

3. Procédé selon la revendication 1, **caractérisé en ce que**
dans l'étape a), la valeur réelle mesurée de la charge est un courant réel (i1..n) traversant chaque module de commutation (1),
la valeur de consigne de la charge de chaque module de commutation (1) soit une valeur de consigne prédéfinie du courant (isoll1..n) et
dans l'étape b), la différence entre la valeur de consigne du courant (isoll1..n) et le courant réel (i1..n) soit utilisée comme différence entre la valeur de consigne de la charge et la valeur réelle de la charge.

4. Procédé selon la revendication 3, **caractérisé par** l'étape supplémentaire consistant à mesurer le courant total (itot) et à calculer la nième partie du courant total mesuré (itot) en tant que valeur de consigne du courant (isoll1..n), n correspondant ici au nombre de modules de commutation (1) branchés en parallèle.

5. Procédé selon la revendication 3, **caractérisé en ce qu'**une valeur de consigne du courant (isoll1) soit attribuée à un premier module de commutation (1) et que le courant réel (i1) du premier module de commutation (1) soit utilisé comme valeur de consigne du courant (isoll2..n) des autres modules de commutation (1).

6. Procédé selon l'une des revendications 3 à 5, **caractérisé par** une étape supplémentaire consistant à mesurer une température Ts du commutateur à semiconducteur de puissance (2), à calculer une différence à chaque fois entre une valeur maximale de la température Tmax et la température mesurée Ts et à réduire la valeur de consigne du courant (isoll1..n) en fonction du montant de la différence si la température mesurée Ts dépasse la valeur maximale Tmax.

7. Dispositif pour symétriser la répartition de la charge d'au moins deux modules de commutation (1) branchés en parallèle, comprenant :
a) au moins deux modules de commutation (1) branchés en parallèle, les modules de commutation (1) comprenant au moins un commutateur à semiconducteur de puissance (2) avec une borne de gâchette, lequel peut être activé ou désactivé manière répétée à des moments de commutation quelconques (ton, toff) à l'aide d'un signal de commande impulsionnel (UGE) et prend ainsi un état passant ou un état bloqué,
b) un dispositif pour mesurer une valeur réelle de la charge de chaque module de commutation (1), un dispositif pour calculer la différence entre une valeur de consigne de charge et la valeur réelle de la charge,
c) un dispositif pour régler des moments d'activation et de désactivation (ton, toff) du signal de commande (UGE) de chaque commutateur à semiconducteur de puissance (2) au moyen de la différence entre la valeur de consigne de la charge (isoll1..n ; Tmax) et la valeur réelle de la charge (i1..n ; Ts) de telle manière qu'en cas de différence négative, le module de commutation (1) soit activé plus tard à la prochaine commutation et, en cas de différence positive, le module de commutation (1) soit activé plus tôt à la prochaine commutation,
**caractérisé en ce que**
l'intensité du courant peut être commandée par le biais de la borne de gâchette à l'aide du signal de commande impulsionnel (UGE) et
d) un dispositif pour régler l'amplitude du signal de commande (UGE) pour chaque module de commutation (1) de telle manière qu'en cas de différence négative entre une valeur de consigné de la charge et une valeur réelle de la charge, l'amplitude du signal de commande soit diminuée et, en cas de différence positive, l'amplitude du signal de commande soit augmentée.

8. Dispositif selon la revendication 7, **caractérisé en ce que**
le dispositif de mesure d'une valeur réelle de la charge est un dispositif de mesure de la température (17) à la sortie de chaque module de commutation (1), lequel mesure une température Ts du commutateur à semiconducteur de puissance (2),
chaque module de commutation (1) présente une unité de régulation (3) munie d'une entrée de signal de commande (13) qui est alimentée par une source de signal de commande et d'une entrée (18) pour la valeur maximale de la température Tmax,
chaque unité de régulation (3) comprenant un comparateur de température (12) faisant office de dispositif pour calculer la différence entre une valeur de consigne de la charge et une valeur réelle de la charge, lequel calcule la différence entre la valeur maximale de la température Tmax et la température Ts mesurée dans le dispositif de mesure de la température (17) correspondant, et
chaque unité de régulation (3) présentant un régulateur de compensation (6) faisant office de dispositif pour régler l'amplitude du signal de sortie, dans lequel est déterminée l'amplitude des signaux de commande (UGE) à l'aide de la différence entre la valeur maximale de la température Tmax et la température mesurée Ts, et
un générateur de signal de commande (7) par commutateur à semiconducteur de puissance (2), dans lequel le signal (Ust) appliqué à l'entrée de signal de commande (13) est modifié en fonction de l'amplitude du signal de commande (UGE) déterminée dans le régulateur de compensation (6).

9. Dispositif selon la revendication 7, **caractérisé en ce que**
le dispositif de mesure d'une valeur réelle de la charge est un dispositif de mesure du courant (4) à la sortie de chaque module de commutation (1),
lequel mesure la valeur réelle du courant (i1..n) du commutateur à semiconducteur de puissance (2),
chaque module de commutation (1) présente une unité de régulation (3) munie d'une entrée de signal de commande (13) qui est alimentée par une source de signal de commande et d'une entrée (14) pour la valeur de consigne du courant (isoll1..n), chaque unité de régulation (3) comprenant un générateur différentiel (5) faisant office de dispositif pour calculer une différence, lequel calcule une différence entre la valeur de consigne du courant (isoll1..n) et la valeur réelle du courant (i1..n) mesurée dans le dispositif de mesure du courant (4) correspondant, et chaque unité de régulation présentant par module de commutation (1) un régulateur de compensation (6) faisant office de dispositif pour régler l'amplitude du signal de commande, dans lequel sont déterminés les moments d'activation et de désactivation (ton, toff) ainsi que l'amplitude des signaux de commande (UGE) à l'aide de la différence, et un générateur de signal de commande (7) est prévu pour chaque commutateur à semiconducteur de puissance (2), dans lequel le signal (Ust) appliqué à l'entrée de signal de commande (13) est modifié en fonction des moments d'activation et de désactivation (ton, toff) et de l'amplitude du signal de commande (UGE) déterminés dans le régulateur de compensation (6).

10. Dispositif selon la revendication 9, **caractérisé en ce que** un dispositif de mesure du courant supplémentaire (9) est réalisé à la sortie (8) du circuit parallèle composé des modules de commutation (1), lequel mesure une somme des courants (i1..n) délivrés par les modules de commutation (1), divise ce courant total (itot) par le nombre de modules de commutation (1) et transmet le résultat à l'entrée (14) de valeur de consigne du courant de l'unité de régulation (3).

11. Dispositif selon la revendication 9, **caractérisé en ce qu'**il est prévu un calculateur de valeur moyenne (10) qui calcule une valeur moyenne des courants réels (i1..n) mesurés dans les dispositifs de mesure du courant (4) des modules de commutation (1) et transmet celle-ci sous la forme d'une valeur de consigne du courant (isoll1..n) à l'entrée (14) de valeur de consigne du courant de l'unité de régulation (3).

12. Dispositif selon la revendication 9, **caractérisé en ce qu'**une valeur de consigne du courant (isoll1) est communiquée depuis l'extérieur à un premier module de commutation (1) et les entrées (14) de valeur de consigne du courant des unités de régulation (3) des autres modules de commutation (1) sont reliées au dispositif de mesure du courant (4) du premier module de commutation (1).

13. Dispositif selon l'une des revendications 9 à 12,
**caractérisé en ce que**
il est prévu un comparateur de température (12) qui détermine une différence entre une valeur maximale de la température Tmax et une température mesurée Ts sur les commutateurs à semiconducteur de puissance (2),
un générateur de différence supplémentaire (15) est branché en amont du générateur de différence (5), lequel soustrait de la valeur de consigne du courant (isoll1..n) un montant proportionnel à la différence déterminée entre la valeur maximale de la température Tmax et la température mesurée Ts lorsque la température mesurée Ts dépasse la valeur maximale de la température Tmax.
